(19) Europäisches Patentamt
European Patent Office
Office européen des brevets

(11) EP 1 826 826 A1

(12) **EUROPEAN PATENT APPLICATION**
published in accordance with Art. 158(3) EPC

(43) Date of publication:
**29.08.2007 Bulletin 2007/35**

(21) Application number: **05811473.7**

(22) Date of filing: **24.11.2005**

(51) Int Cl.:
***H01L 31/048*** *(2006.01)*

(86) International application number:
**PCT/JP2005/022034**

(87) International publication number:
**WO 2006/057428 (01.06.2006 Gazette 2006/22)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.11.2004 JP 2004340119**
**01.06.2005 JP 2005161470**

(71) Applicant: **Teijin Dupont Films Japan Limited**
**Tokyo 100-0011 (JP)**

(72) Inventor: **KUBO, Koji,**
**Teijin DuPont Films Japan Limited**
**Anpachi-gun, Gifu 503-0123 (JP)**

(74) Representative: **Cockerton, Bruce Roger et al**
**Carpmaels & Ransford,**
**43-45 Bloomsbury Square**
**London WC1A 2RA (GB)**

(54) **HIGHLY ADHESIVE POLYESTER FILM AND FILM FOR PROTECTING BACK SIDE OF SOLAR CELL USING SAME**

(57) An easily adhesive polyester film is provided which is used for protection of the back side of a solar cell, the adhesive polyester film comprising a polyester film and a resin film situated on a surface of the polyester film, the resin film comprising a crosslinking agent and a resin selected from the group consisting of a polyester resin having a glass transition point of 20 to 100˚C, an acrylic resin having a glass transition point of 20 to 100˚C, a combination of the resins and a combination of at least one of the resins and a polyvinyl alcohol having a saponification degree of 70 to 90 mol%. This film has excellent adhesion to EVA while having excellent mechanical properties, heat resistance and moisture resistance.

EP 1 826 826 A1

## Description

Field of the Invention

This invention relates to an easily adhesive film and a film for protecting the back side of a solar cell. More specifically, it relates to an easily adhesive polyester film which shows excellent adhesion to an ethylene-vinyl acetate copolymer (hereinafter abbreviated as "EVA") which is a sealing resin for a solar cell by having an easily adhesive coating film comprising a specific composition on at least one surface of a polyester film and to a film for protecting the back side of a solar cell which uses the easily adhesive polyester film.

Background Art

In recent years, a photovoltaic system has been becoming widely used as electric power generating means using clean energy. As described in Japanese Utility Model Laid-Open Publication No.6-38264, a solar cell module generally has a structure that a plurality of plate-like solar cell elements are situated between a glass substrate on the light receiving side and a protective film on the back side and a sealing resin is filled in internal gaps. As the sealing resin, EVA is used because it has high transparency and excellent moisture resistance.

As the protective film on the back side, a polyethylene resin, a polyester resin sheet or a fluorine resin film is used (refer to Japanese Patent Laid-Open Publication Nos.11-261085 and 11-186575). However, these protective films are not satisfactory for durability in long term due to low adhesive with EVA.

Meanwhile, a polyester film obtained by stretching a polyester sheet has excellent mechanical properties, heat resistance and moisture resistance. However, the polyester film, particularly a biaxially stretched, highly oriented and crystallized polyester film has inert surfaces and shows very poor adhesion to EVA. To improve the adhesion of such a polyester film and EVA, lamination of thermal adhesion layer comprising a styrene-olefin copolymer resin is proposed in Japanese Patent Laid-Open Publication No.2003-60218. However, the effect of the thermal adhesion layer is not satisfactory, and it cannot be used in building a large-scale photovoltaic system.

Disclosure of the Invention

An object of the present invention is to provide an easily adhesive polyester film for a film for protecting the back side of a solar cell which is free from the problems of the prior art and has excellent adhesion to EVA while having excellent mechanical properties, heat resistance and moisture resistance.

Another object of the present invention is to provide a film for protecting the back side of a solar cell which comprises the above easily adhesive polyester film of the present invention.

Other objects and advantages of the present invention will become apparent from the following description.

According to the present invention, firstly, the above objects and advantages of the present invention are achieved by an easily adhesive polyester film which is used for protection of the back side of a solar cell, the adhesive polyester film comprising a polyester film and a resin film situated on a surface of the polyester film, the resin film comprising a crosslinking agent and a resin selected from the group consisting of a polyester resin having a glass transition point of 20 to 100˚C, an acrylic resin having a glass transition point of 20 to 100˚C, a combination of the resins and a combination of at least one of the resins and a polyvinyl alcohol having a saponification degree of 70 to 90 mol%.

Further, according to the present invention, secondly, the above objects and advantages of the present invention are achieved by a film for protecting the back side of a solar cell which comprises the above easily adhesive polyester film of the present invention.

Best Mode for Carrying out the Invention

Hereinafter, the present invention will be further described.

[Polyester Film]

The polyester which constitutes the easily adhesive polyester film in the present invention may be an aromatic polyester comprising an aromatic dicarboxylic acid component such as terephthalic acid, isophthalic acid, 2,6-naphthalene dicarboxylic acid or 4,4'-diphenyldicarboxylic acid and an aliphatic glycol component such as ethylene glycol, 1,4-butanediol, 1,4-cyclohexane dimethanol or 1,6-hexanediol. These polyesters may be copolyesters. Of these, polyethylene terephthalate and polyethylene-2,6-naphthalene dicarboxylate are preferred, and polyethylene-2,6-naphthalene dicarboxylate is particularly preferred.

The polyester may contain organic or inorganic fine particles as a lubricant as required so as to improve the

windability of a film at the time of film production and the transportability of a film in a step of forming a film for protecting the back side of a solar cell. Illustrative examples of the fine particles include calcium carbonate, calcium oxide, aluminum oxide, kaolin, silicon oxide, zinc oxide, crosslinked acrylic resin particles, crosslinked polystyrene resin particles, urea resin particles, melamine resin particles, and crosslinked silicone resin particles.

The average particle diameter of the fine particles may be 0.05 to 10 μm. The fine particles are preferably contained in an amount of 0.005 to 1 wt% based on the polyester.

The polyester may be colored white, black or other color from the viewpoints of an improvement in surface reflectance and design as a film for protecting the back side of a solar cell. Further, the polyester may contain an ultraviolet absorber as described hereinafter.

[Resin Film]

In the present invention, the resin film on the polyester film comprises a resin and a crosslinking agent. As the crosslinking agent, an oxazoline-group-containing polymer, an epoxy resin, an urea resin or a melamine resin can be used, for example. These may be used alone or in combination of two or more.

Illustrative examples of the oxazoline-group-containing polymer include polymers described in Japanese Patent Publication No. 63-48884 and Japanese Patent Laid-Open Publications Nos. 2-60941 and 2-99537 and polymers related to these polymers. A specific example thereof is a polymer which is obtained by polymerizing an addition-polymerizable oxazoline

(a) represented by the following formula (III):

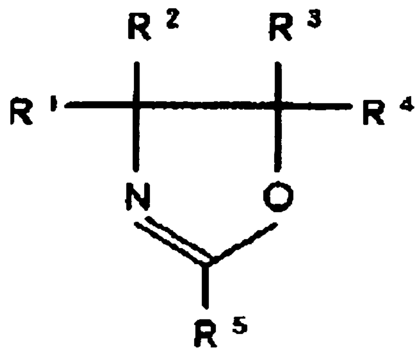

· · · (III)

wherein $R^1$, $R^2$, $R^3$ and $R^4$ each represent a hydrogen atom, a halogen atom, an alkyl group, an aralkyl group, a phenyl group or a substituted phenyl group, and $R^5$ represents an acyclic organic group having an addition-polymerizable unsaturated bond group,
with other monomer (b) as required.

Specific examples of the addition-polymerizable oxazoline (a) represented by the above formula (III) include
2-vinyl-2-oxazoline,
2-vinyl-4-methyl-2-oxazoline,
2-vinyl-5-methyl-2-oxazoline,
2-isopropenyl-2-oxazoline,
2-isopropenyl-4-methyl-2-oxazoline, and
2-isopropenyl-5-methyl-2-oxazoline. These may be used alone or in admixture of two or more. Of these, 2-isopropenyl-2-oxazoline is easy to obtain and suitable from an industrial standpoint.

The above monomer (b) other than the addition-polymerizable oxazoline is not particularly limited as long as it is a monomer copolymerizable with the addition-polymerizable oxazoline (a). Illustrative examples thereof include acrylic acid esters such as methyl acrylate, methyl methacrylate, butyl acrylate and butyl methacrylate; unsaturated carboxylic acids such as acrylic acid, methacrylic acid and itaconic acid; unsaturated nitriles such as acrylonitrile and methacrylonitrile; unsaturated amides such as acrylamide, methacrylamide, N-methylol acrylamide and N-methylol methacrylamide; vinyl esters such as vinyl acetate and vinyl propionate; vinyl ethers such as methylvinyl ether and ethylvinyl ether; α-olefins such as ethylene and propylene; halogen-containing-α,β-unsaturated monomers such as vinyl chloride, vinylidene chloride and vinyl fluoride; and α,β-unsaturated aromatic monomers such as styrene and α-methyl styrene. These may be used alone or in admixture of two or more.

The polymer comprising the above addition-polymerizable oxazoline (a) and at least one other monomer (b)

as required can be obtained by polymerizing them in accordance with a conventionally known polymerization method. As the polymerization method, various methods such as an emulsion polymerization method (comprising mixing a polymerization catalyst, water, a surfactant and monomers at a time and polymerizing them), a monomer instillation method, a multistep polymerization method and a preemulsion method can be employed.

As the polymerization catalyst, conventionally known ones can be used. For example, conventional radical polymerization initiators such as hydrogen peroxide, potassium persulfate and 2,2'-azobis(2-aminodipropane) dihydrochloride can be used.

Further, as the surfactant, conventionally known anionic, nonionic, cationic, amphoteric and reactive surfactants can be used.

The polymerization temperature is 0 to 100°C, preferably 50 to 80°C, for example. Further, the polymerization time is 1 to 10 hours, for example.

When a polymer is obtained by use of the addition-polymerizable oxazoline (a) and at least one other monomer (b), the addition-polymerizable oxazoline (a) is preferably used in an amount of at least 0.5 wt% based on all monomers. When the amount of the addition-polymerizable oxazoline (a) is smaller than 0.5 wt%, the objects of the present invention may become difficult to achieve.

Specific examples of the epoxy resin used as the above crosslinking agent include a polyepoxy compound, a diepoxy compound, and a monoepoxy compound. Illustrative examples of the polyepoxy compound include sorbitol polyglycidyl ether, polyglycerol polyglycidyl ether, pentaerythritol polyglycidyl ether, diglycerol polyglycidyl ether, triglycidyl tris(2-hydroxyethyl)isocyanate, glycerol polyglycidyl ether, trimethylolpropane polyglycidyl ether, N,N,N',N'-tetraglycidyl meta-xylylene diamine, N,N,N',N'-tetraglycidyl-4,4'-diaminodiphenylmethane, and N,N,N',N'-tetraglycidyl-1,3-bisaminomethyl cyclohexane. Illustrative examples of the diepoxy compound include neopentyl glycol diglycidyl ether, 1,6-hexanediol diglycidyl ether, resorcin diglycidyl ether, ethylene glycol diglycidyl ether, polyethylene glycol diglycidyl ether, propylene glycol diglycidyl ether, polypropylene glycol diglycidyl ether, and polytetramethylene glycol diglycidyl ether. Illustrative examples of the monoepoxy compound include allyl glycidyl ether, 2-ethylhexyl glycidyl ether, and phenyl glycidyl ether. Of these, N,N,N',N'-tetraglycidyl meta-xylylene diamine, N,N,N',N'-tetraglycidyl-4,4'-diaminodiphenylmethane and N,N,N',N'-tetraglycidyl-1,3-bisaminomethyl cyclohexane are preferred.

Preferred examples of the urea resin used as the above crosslinking agent include dimethylol urea, dimethylol ethylene urea, dimethylol propylene urea, tetramethylol acetylene urea, and 4-methoxy-5-dimethyl propylene urea dimethylol.

Preferred examples of the melamine resin used as the above crosslinking agent include compounds resulting from etherification of a methylol melamine derivative obtained by condensation of melamine and formaldehyde with a lower alcohol such as methyl alcohol, ethyl alcohol or isopropyl alcohol, and mixtures of these compounds.

Illustrative examples of the methylol melamine derivative include monomethylol melamine, dimethylol melamine, trimethylol melamine, tetramethylol melamine, pentamethylol melamine, and hexamethylol melamine.

Of these crosslinking agents, the oxazoline-group-containing polymer is preferred because it shows particularly excellent easy adhesion. The crosslinking agents may be used alone or in combination of two or more.

As the resin which forms the resin film together with these crosslinking agents, a polyester resin having a glass transition point of 20 to 100°C, an acrylic resin having a glass transition point of 20 to 100°C, a combination of these resins and a combination of at least one of these resins or combination thereof with a polyvinyl alcohol having a saponification degree of 70 to 90 mol% are used.

The glass transition point of the polyester resin or acrylic resin is preferably 30 to 90°C. When the glass transition point is lower than 20°C, blocking may occur between the films, while when it is higher than 100°C, a coating layer becomes brittle and adhesion may not be retained disadvantageously.

As the polyester resin having a glass transition point of 20 to 100°C, polyesters comprising the following polybasic acids or ester-forming derivatives thereof and polyols or ester-forming derivatives thereof can be used. That is, illustrative examples of the polybasic acid components include terephthalic acid, isophthalic acid, phthalic acid, phthalic anhydride, 2,6-naphthalene dicarboxylic acid, 1,4-cyclohexane dicarboxylic acid, adipic acid, sebacic acid, trimellitic acid, pyromellitic acid, dimer acid, and 5-sodium sulfoisophthalate. Two or more of these acid components are used to synthesize a copolyester resin. Further, in a small amount, e.g. 10 mol% or smaller based on the above polybasic acid component, an unsaturated polybasic acid component such as maleic acid or itaconic acid and a hydroxycarboxylic acid such as p-hydroxybenzoic acid can be used. Meanwhile, illustrative examples of the polyol components include ethylene glycol, 1,4-butanediol, diethylene glycol, dipropylene glycol, 1,6-hexanediol, 1,4-cyclohexane dimethanol, xylene glycol, dimethylol propane, poly(ethyleneoxide)glycol, and poly(tetramethyleneoxide) glycol. Further, their monomers can also be used.

Meanwhile, as the acrylic resin having a glass transition point of 20 to 100°C, acrylic resins obtained by polymerizing the following acryl monomers can be used. Illustrative examples of the acryl monomers include alkyl acrylate and alkyl methacrylate (wherein the alkyl group is a methyl, ethyl, n-propyl, isopropyl, n-butyl, isobutyl, t-butyl, 2-ethylhexyl or cyclohexyl group or other group) ; hydroxyl-group-containing monomers such as 2-hydroxyethyl acrylate, 2-hydroxyethyl methacrylate, 2-hydroxypropyl acrylate and 2-hydroxypropyl methacrylate; epoxy-group-containing monomers such as glycidyl acrylate, glycidyl methacrylate and allyl glycidyl ether; monomers containing a carboxyl group or a salt thereof such as acrylic acid, methacrylic acid, itaconic acid, maleic acid, fumaric acid, crotonic acid, styrene sulfonic acid and salts thereof (such as a sodium salt, potassium salt, ammonium salt or tertiary amine salt); monomers containing an amide group such as acrylamide, methacrylamide, N-alkyl acrylamide, N-alkyl methacrylamide, N,N-dialkyl acrylamide, N,N-dialkyl methacrylate (wherein the alkyl group is a methyl, ethyl, n-propyl, isopropyl, n-butyl, isobutyl, t-butyl, 2-ethylhexyl or cyclohexyl group or other group), N-alkoxy acrylamide, N-alkoxy methacrylamide, N,N-dialkoxy acrylamide, N,N-dialkoxy methacrylamide (wherein the alkoxy group is a methoxy, ethoxy, butoxy or isobutoxy group or other group), acryloyl morpholine, N-methylol acrylamide, N-methylol methacrylamide, N-phenyl acrylamide and N-phenyl methacrylamide; acid anhydride monomers such as maleic anhydride and itaconic anhydride; and monomers such as vinyl isocyanate, allyl isocyanate, styrene, $\alpha$-methyl styrene, vinylmethyl ether, vinylethyl ether, vinyl trialkoxysilane, alkyl maleic monoester, alkyl fumaric monoester, alkyl itaconic monoester, acrylonitrile, methacrylonitrile, vinylidene chloride, ethylene, propylene, vinyl chloride, vinyl acetate and butadiene.

Of these, the hydroxyl-group-containing monomer such as 2-hydroxyethyl acrylate, 2-hydroxyethyl methacrylate, 2-hydroxypropyl acrylate, 2-hydroxypropyl methacrylate, N-methylol acrylamide or N-methylol methacrylamide is preferably contained in an amount of 2 to 20 mol%, more preferably 4 to 15 mol%.

The saponification degree of the polyvinyl alcohol is 70 to 90 mol%. When it is higher than 90 mol%, satisfactory adhesion to EVA is not obtained disadvantageously, while when it is lower than 70 mol%, moisture resistance is poor disadvantageously.

The resin film preferably comprises 20 to 95 wt% of the resin and 5 to 80 wt% of the crosslinking agent, more preferably 40 to 90 wt% of the resin.

The resin film may contain inert fine particles so as to improve ease of handling of the film and prevent blocking between the films. As the fine particles, organic or inorganic fine particles can be used. Illustrative examples of the fine particles include calcium carbonate, calcium oxide, aluminum oxide, kaolin, silicon oxide, zinc oxide, crosslinked acrylic resin particles, crosslinked polystyrene resin particles, melamine resin particles, and crosslinked silicone resin particles.

The average particle diameter of the fine particles is preferably 20 to 200 nm, more preferably 30 to 120 nm. The amount of the fine particles is preferably 1 to 20 wt%, more preferably 2 to 15 wt%, based on the resin film.

The resin film may further contain wax so as to obtain better easy slipperiness. Specific examples of the wax include plant waxes such as carnauba wax, candelilla wax, rice wax, Japan wax, jojoba wax, palm wax, rosin modified wax, auriculy wax, sugarcane wax, esparto wax and bark wax; animal waxes such as beeswax, lanolin, whale wax, privet wax and shellac wax; mineral waxes such as montan wax, ozocerite and ceresin wax; petroleum waxes such as paraffin wax, microcrystalline wax and petrolactam; and synthetic hydrocarbon waxes such as Fischer-Tropsch wax, polyethylene wax, oxidized polyethylene wax, polypropylene wax and oxidized polypropylene wax. Of these, carnauba wax, paraffin wax and polyethylene wax are preferred because they show good easy adhesion to a hard coating and an adhesive and good slipperiness. The wax is preferably used as a water dispersion from the viewpoints of reduction of environmental burdens and ease of handling.

As components which form the resin film, an antistatic agent, colorant, surfactant and ultraviolet absorber may also be contained.

[Production of Easily Adhesive Polyester Film]

The easily adhesive polyester film of the present invention is produced by coating at least one surface of the polyester film with the resin film comprising the above components. The resin film is preferably formed by applying an aqueous solution containing the components which form the film on the stretchable polyester film whose crystalline orientation is not yet completed and drying, stretching and heat-treating the film. The solid concentration of this aqueous solution is preferably not higher than 30 wt%, more preferably not higher than 10 wt%.

The coating solution preferably contains 10 to 80 wt% of the crosslinking agent and 20 to 90 wt% of the resin component other than the crosslinking agent based on 100 wt% of solid. When the amount of the resin component other than the crosslinking agent is smaller than 20 wt%, the coating film is difficult to form, resulting in insufficient adhesion to EVA disadvantageously. When it is larger than 90 wt%, the amount of the crosslinking agent (A) becomes insufficient, so that the cohesive force of the coating layer is lowered, and particularly, durability of adhesion in a high-humidity atmosphere deteriorates disadvantageously.

The above stretchable polyester film is an unstretched polyester film, a monoaxially stretched polyester film or a biaxially stretched polyester film. Of these, a longitudinally stretched polyester film which has been monoaxially stretched in the film extruding direction (longitudinal direction) is particularly preferred.

When the aqueous coating solution is applied to the film, it is preferred to subject the surface of the film to a physical treatment such as a corona surface treatment, flame treatment or plasma treatment as a preliminary treatment for improving coatability or to use the composition in combination with a surfactant which is chemically inactive to the

composition.

The surfactant promotes wetting of the aqueous coating solution on the polyester film. Illustrative examples of the surfactant include anionic or nonionic surfactants such as polyoxyethylene alkylphenyl ether, polyoxyethylene-fatty acid ester, sorbitan fatty acid ester, glycerin fatty acid ester, fatty acid metallic soap, alkyl sulfate, alkyl sulfonate, and alkyl sulfosuccinate. The surfactant is preferably contained in the composition which forms the coating film in an amount of 1 to 10 wt%. When the amount is within this range, the aqueous coating solution can be lowered to 40 mN/m or lower, and repelling of the coating layer can be prevented.

When the aqueous solution is applied on the polyester film by a general coating process, i.e. a process which is independent of the production process of the film and in which the aqueous solution is applied on the biaxially stretched and heat-set polyester film, dirt, dust or the like is liable to be included in the coating film disadvantageously. From this viewpoint, application of the coating solution in a clean atmosphere, i.e. in the film production process, is desired. Thereby, adhesion of the resin film as a coating film to the polyester film is further improved.

To apply the aqueous solution, any known coating method can be used. For example, roll coating, gravure coating, roll brush coating, spray coating, air knife coating, impregnation and curtain coating may be used alone or in combination. The aqueous solution is applied in an amount of preferably 0.5 to 20 g, more preferably 1 to 10 g, per $m^2$ of the running film. The aqueous solution is preferably used as a water dispersion or emulsion. The aqueous solution is applied only one surface of the film.

After coated with the aqueous solution, the stretchable polyester film is subjected to a drying step and a stretching step as required. These treatments can be conducted under conditions which has been collected in the field. As for preferred conditions, the drying condition is 90 to 130˚C for 2 to 10 seconds, the stretch temperature is 90 to 150˚C, the stretch ratios are 3 to 5 times in the longitudinal direction and 3 to 5 times in the transverse direction and, if necessary, 1 to 3 times in the longitudinal direction again, and the heat-setting condition is 180 to 250˚C for 2 to 60 seconds.

After these treatments, the thickness of the biaxially oriented polyester film is preferably 50 to 250 μm, and the thickness of the coating film is preferably 0.01 to 1 μm.

The above polyester film may contain an ultraviolet absorber so as to improve the weather resistance of the film. As the ultraviolet absorber, at least one compound selected from the group consisting of a cyclic imino ester represented by the following formula (I):

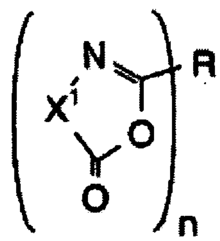

・・・(I)

(wherein $X^1$ is a divalent aromatic residue having two bonding hands at first and second positions, n is 1, 2 or 3, $R^1$ is an n-valent hydrocarbon residue which may contain a hetero atom or $R^1$ may be a direct bond when n = 2),
and a cyclic imino ester represented by the following formula (II):

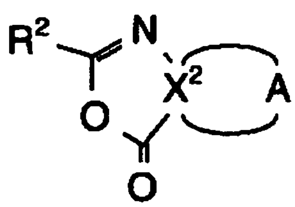

・・・(II)

(wherein A is a group represented by the following formula (II)-a:

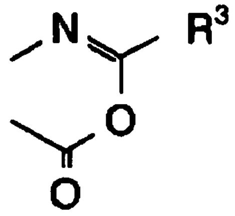

・・・(II) -a

or a group represented by the following formula (II) -b:

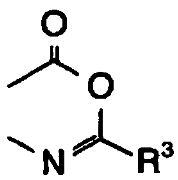

・・・(II) -b

, $R^2$ and $R^3$ are the same or different and are a monovalent hydrocarbon residue, and $X^2$ is a tetravalent aromatic residue which may contain a hetero atom), is used preferably in an unreacted form.

The cyclic imino esters are known compounds as ultraviolet absorbers and are disclosed in Japanese Patent Laid-Open Publication No.59-12952, for example.

In the above formula (I), $X^1$ is a divalent aromatic residue having two bonding hands at first and second positions, n is 1, 2 or 3, $R^1$ is an n-valent hydrocarbon residue which may contain a hetero atom or $R^1$ may be a direct bond when n = 2.

Preferred examples of $X^1$ include 1,2-phenylene, 1,2-naphthylene, 2,3-naphthylene, and groups represented by the following formulae (a) and (b):

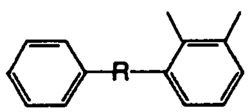

・・・(a)

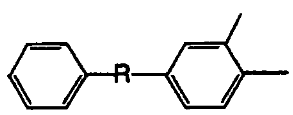

・・・(b)

(wherein R is -O-, -CO-, -S-, $-SO_2-$ $-CH_2-$, - $(CH_2)$ - or $-C(CH_3)_2-$.) Of these, 1,2-phenylene is particularly preferred.

The above aromatic residues enumerated as examples of $X^1$ may be substituted with a substituent, e.g. alkyl having 1 to 10 carbon atoms such as methyl, ethyl, propyl, hexyl or decyl ; aryl having 6 to 12 carbon atoms such as phenyl or naphthyl; cycloalkyl having 5 to 12 carbon atoms such as cyclopentyl or cyclohexyl; aralkyl having 8 to 20 carbon atoms such as phenylethyl; alkoxy having 1 to 10 carbon atoms such as methoxy, ethoxy or decyloxy; nitro; halogen such as chlorine or bromine; and acyl having 2 to 10 carbon atoms such as acetyl, proponyl, zenzoyl or decanoyl.

$R^1$ is an n-valent (wherein n is 1, 2 or 3) hydrocarbon residue or may be a direct bond only when n is 2.

Illustrative examples of monovalent hydrocarbon residue (when n = 1) include, firstly, an unsubstituted aliphatic group having 1 to 10 carbon atoms, an unsubstituted aromatic group having 6 to 12 carbon atoms, and an unsubstituted alicyclic group having 5 to 12 carbon atoms.

Illustrative examples of the unsubstituted aliphatic group having 1 to 10 carbon atoms include methyl, ethyl, propyl, hexyl and decyl. Illustrative examples of the unsubstituted aromatic group having 6 to 12 carbon atoms include phenyl, naphthyl and biphenyl. Illustrative examples of the unsubstituted alicyclic group having 5 to 12 carbon atoms include cyclopentyl and cyclohexyl.

Further, illustrative examples of the above monovalent hydrocarbon residue include, secondly, substituted aliphatic residues or aromatic residues represented by the following formula (c):

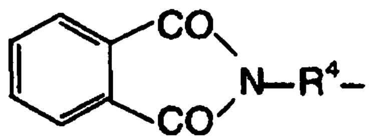

• • • (c)

(wherein $R^4$ is alkylene having 2 to 10 carbon atoms, phenylene or naphthylene),
the following formula (d):

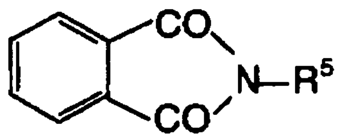

• • • (d)

(wherein $R^5$ is an alkyl group having 1 to 10 carbon atoms, a phenyl group or a naphthyl group),
the following formula (e):

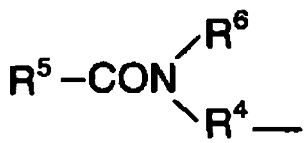

• • • (e)

(wherein $R^4$ and $R^5$ are the same as defined above, and $R^6$ is a hydrogen atom or any of the groups defined for $R^5$),
or the following formula (f):

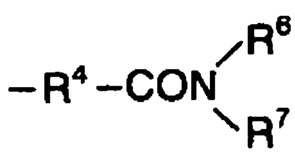

• • • (f)

(wherein $R^4$ and $R^6$ are the same as defined above, and $R^7$ is a hydrogen atom or any of the groups defined for $R^5$) .

Further, illustrative examples of the above monovalent hydrocarbon residue include, thirdly, aromatic residues resulting from substituting the above unsubstituted aromatic residues with the same substituents as those enumerated above as examples of substituents for the aromatic residues representing $X^1$. Accordingly, illustrative examples of the aromatic residues substituted with the substituents include tolyl, methylnaphthyl, nitrophenyl, nitronaphthyl, chlorophenyl, benzoylphenyl, acetylphenyl, and acetylnaphthyl.

As the monovalent hydrocarbon residue, the group represented by the above formula (c), (d), (e) or (f), i.e. substituted aliphatic residue or aromatic residue, is preferred. Of these, the substituted aromatic residue is particularly preferred.

Illustrative examples of divalent hydrocarbon residue (when n = 2) include, firstly, an unsubstituted divalent aliphatic residue having 2 to 10 carbon atoms, an unsubstituted divalent aromatic residue having 6 to 12 carbon atoms, and an unsubstituted divalent alicyclic residue having 5 to 12 carbon atoms.

Illustrative examples of the unsubstituted divalent aliphatic residue having 2 to 10 carbon atoms include ethylene, trimethylene, tetramethylene and decamethylene. Illustrative examples of the unsubstituted divalent aromatic residue having 6 to 12 carbon atoms include phenylene, naphthylene and p,p'-biphenylene. Illustrative examples of the unsubstituted divalent alicyclic residue having 5 to 12 carbon atoms include cyclopentylene and cyclohexylene.

Further, illustrative examples of the above divalent hydrocarbon residue include, secondly, substituted aliphatic residues or aromatic residues represented by the following formula (g):

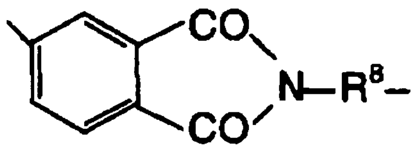

・・・(g)

(wherein $R^8$ is any of the groups defined for $R^4$),
or the following formula (h):

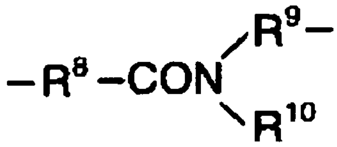

・・・(h)

(wherein $R^8$ is the same as defined above, $R^9$ is any of the groups defined for $R^4$, and $R^{10}$ is any of the groups defined for $R^6$).

Further, illustrative examples of the above divalent hydrocarbon residue include, thirdly, divalent aromatic residues resulting from substituting the above unsubstituted divalent aromatic residues with the same substituents as those enumerated above as examples of substituents for the aromatic residues representing $X^1$.

When n is 2, $R^1$ is preferably a direct bond or an unsubstituted or substituted divalent aromatic hydrocarbon residue out of the above first to third groups, particularly preferably an unsubstituted or substituted aromatic hydrocarbon residue having the two bonding hands at the most distant positions out of the above first or third groups. Particularly, p-phenylene, p,p'-biphenylene or 2,6-naphthylene is preferred.

Illustrative examples of trivalent hydrocarbon residue (when n = 3) include trivalent aromatic residues having 6 to 12 carbon atoms.

Illustrative examples of the aromatic residues include the following groups.

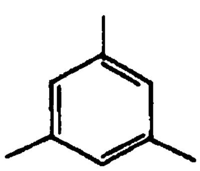 , 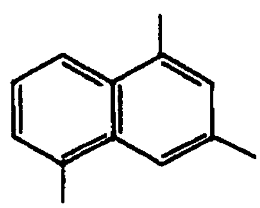 ,

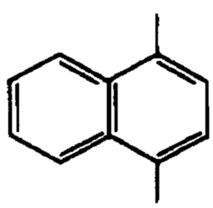 , 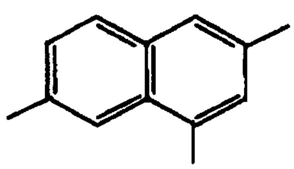 ,

The aromatic residues may be substituted with the same substituents as those enumerated as examples of substituents for the above monovalent aromatic residue.

In the above formula (II), $R^2$ and $R^3$ are the same or different and are a monovalent hydrocarbon residue, and $X^2$ is a tetravalent aromatic hydrocarbon residue.

$R^2$ and $R^3$ are exemplified by the same groups as those enumerated for $R^1$ when n = 1 in the description of the above formula (I).

Illustrative examples of the tetravalent aromatic hydrocarbon residue include groups represented by the following structural formulae:

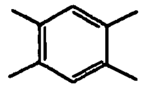 , 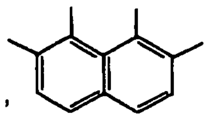 ,

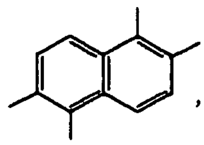 , 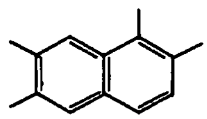 ,

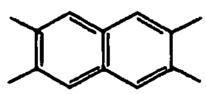 ,

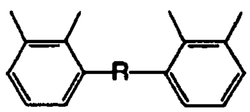 , 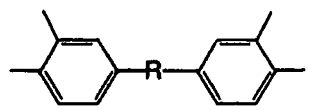 ,

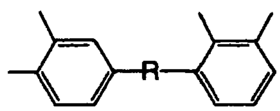

(wherein R is the same as defined in the formula (a)).

The above tetravalent aromatic residues may be substituted with the same substituents as those enumerated as examples of substituents for the monovalent aromatic residue representing $R^1$ in the description of the above formula (I).

Specific examples of the cyclic imino esters of the formulae (I) and (II) which are used in the present invention include the following compounds.

Compounds of Formula (I)

Compounds when n = 1

2-methyl-3,1-benzoxazine-4-one, 2-butyl-3,1-benzoxazine-4-one, 2-phenyl-3,1-benzoxazine-4-one, 2-(1- or 2-naphthyl)-3,1-benzoxazine-4-one, 2-(4-biphenyl)-3,1-benzoxazine-4-one, 2-p-nitrophenyl-3,1-benzoxazine-4-one, 2-m-nitrophenyl-3,1-benzoxazine-4-one, 2-p-benzoylphenyl-3,1-benzoxazine-4-one, 2-p-methoxyphenyl-3,1-benzoxazine-4-one, 2-o-methoxyphenyl-3,1-benzoxazine-4-one, 2-cyclohexyl-3,1-benzoxazine-4-one, 2-p-(or m-) phthalimidephenyl-3,1-benzoxazine-4-one, N-phenyl-4-(3,1-benzoxazine-4-one-2-yl)phthalimide, N-benzoyl-4-(3,1-benzoxazine-4-one-2-yl)aniline, N-benzoyl-N-methyl-4-(3,1-benzoxazine-4-one-2-yl)aniline, and 2-(p-(N-methylcarbonyl)phenyl)-3,1-benzoxazine-4-one.

Compounds when n = 2

2,2'-bis(3,1-benzoxazine-4-one), 2,2'-ethylenebis(3,1-benzoxazine-4-one), 2,2'-tetramethylenebis(3,1-benzoxazine-4-one), 2,2'-decamethylenebis(3,1-benzoxazine-4-one), 2,2'-p-phenylenebis(3,1-benzoxazine-4-one), 2,2'-m-phenylenebis(3,1-benzoxazine-4-one), 2,2'-(4,4'-diphenylene) bis (3,1-benzoxazine-4-one), 2,2'-(2,6- or 1,5-naphthylene) bis (3,1-benzoxazine-4-one), 2,2'-(2-methyl-p-phenylene) bis (3,1-benzoxazine-4-one), 2,2'-(2-nitro-p-phenylene) bis (3,1-benzoxazine-4-one), 2,2'-(2-chloro-p-phenylene) bis (3,1-benzoxazine-4-one), 2,2'-(1,4-cyclohexylene) bis(3,1-benzoxazine-4-one), N-p-(3,1-benzoxazine-4-one-2-yl)phenyl, 4-(3,1-benzoxazine-4-one-2-yl)phthalimide, N-p-(3,1-benzoxazine-4-one-2-yl)benzoyl, and 4-(3,1-benzoxazine-4-one-2-yl)aniline.

Compounds when n = 3

1,3,5-tri(3,1-benzoxazine-4-one-2-yl)benzene, 1,3,5-tri(3,1-benzoxazine-4-one-2-yl)naphthalene, and 2,4,6-tri (3,1-benzoxazine-4-one-2-yl)naphthalene.

Compounds of Formula (II)

2,8-dimethyl-4H,6H-benzo(1,2-d;5,4-d') bis (1,3) -oxazine-4,6-dione, 2,7-dimethyl-4H,9H-benzo (1,2-d;5,4-d') bis (1,3)-oxazine-4,9-dione, 2,8-diphenyl-4H,8H-benzo(1,2-d;5,4-d')bis(1,3)-oxazine-4,6-dione, 2,7-diphenyl-4H,9H-benzo(1,2-d;4,5-d')bis(1,3)-oxazine-4,6-dione, 6,6'-bis(2-methyl-4H,3,1-benzoxazine-4-one), 6,6'-bis(2-ethyl-4H,3,1-benzoxazine-4-one), 6,6'-bis(2-phenyl-4H,3,1-benzoxazine-4-one), 6,6'-methylenebis(2-methyl-4H,3,1-benzoxazine-4-one), 6,6'-methylenebis(2-phenyl-4H,3,1-benzoxazine-4-one), 6,6'-ethylenebis(2-methyl-4H,3,1-benzoxazine-4-one), 6,6'-ethylenebis(2-phenyl-4H,3,1-benzoxazine-4-one), 6,6'-butylenebis(2-methyl-4H,3,1-benzoxazine-4-one), 6,6'-butylenebis(2-phenyl-4H,3,1-benzoxazine-4-one), 6,6'-oxybis(2-methyl-4H,3,1-benzoxazine-4-one), 6,6'-oxybis (2-phenyl-4H,3,1-benzoxazine-4-one), 6,6'-sulfonylbis(2-methyl-4H,3,1-benzoxazine-4-one), 6,6'-sulfonylbis(2-phenyl-4H,3,1-benzoxazine-4-one), 6,6'-carbonylbis(2-methyl-4H,3,1-benzoxazine-4-one), 6,6'-carbonylbis(2-phenyl-4H,3,1-benzoxazine-4-one), 7,7'-methylenebis(2-methyl-4H,3,1-benzoxazine-4-one), 7,7'-methylenebis(2-phenyl-4H,3,1-benzoxazine-4-one), 7,7'-bis(2-methyl-4H,3,1-benzoxazine-4-one), 7,7'-ethylenebis(2-methyl-4H,3,1-benzoxazine-4-one), 7,7'-oxybis(2-methyl-4H,3,1-benzoxazine-4-one), 7,7'-sulfonylbis(2-methyl-4H,3,1-benzoxazine-4-one), 7,7'-carbonylbis(2-methyl-4H,3,1-benzoxazine-4-one), 6,7'-bis(2-methyl-4H,3,1-benzoxazine-4-one), 6,7'-bis(2-phenyl-4H,3,1-benzoxazine-4-one), 6,7'-methylenebis(2-methyl-4H,3,1-benzoxazine-4-one), and 6,7'-methylenebis(2-phenyl-4H,3,1-benzoxazine-4-one).

Of the above enumerated compounds, the compounds of the above formula (I), more preferably the compounds of the above formula (I) when n = 2, particularly preferably compounds represented by the following formula (I)-1:

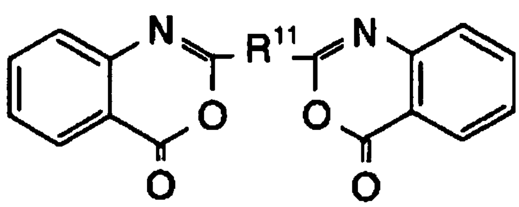

・・・(I) -1

wherein $R^{11}$ is a divalent aromatic hydrocarbon residue, are advantageously used.

As the compounds of the formula (I)-1, 2,2'-p-phenylenebis(3,1-benzoxazine-4-one), 2,2'-(4,4'-diphenylene) bis(3,1-benzoxazine-4-one) and 2,2'-(2,6-naphthylene)bis(3,1-benzoxazine-4-one) are particularly preferred.

As for the ultraviolet absorbability of these cyclic imino esters, description of the ultraviolet absorbability of representative compounds thereof in, for example, Japanese Patent Laid-Open Publication No.59-12952, is incorporated herein.

The above cyclic imino esters have excellent compatibility with a polyester and are capable of reacting the terminal hydroxyl groups of the polyester as described in the above Japanese Patent Laid-Open Publication No.59-12952 and U.S. Patent No. 4291152. Accordingly, to have the cyclic imino ester contained in a substantially unreacted state, it is required to mix the cyclic imino ester with the polyester carefully. However, when a polyester in which most of terminal groups are carboxyl groups or a polyester in which terminal hydroxyl groups are blocked by a terminal blocking agent having no reactivity with the cyclic imino ester is used as the polyester, there is no need to pay special attention

in producing a composition containing the cyclic imino ester in an unreacted state. When a polyester in which most of terminal groups are hydroxyl groups is used, melt mixing is desirably completed in such a short time that the following expressions:

$$\text{Log } t \leq -0.008T + 4.8$$

and

$$Tm < T < 320$$

(wherein t is melt mixing time (seconds), T is melt mixing temperature (˚C), and Tm is the melting temperature (˚C) of polyester),
are satisfied. In this case, the cyclic imino ester and the polyester may react with each other in small amounts, and the molecular weight of the polyester is increased by the reaction. Depending on the amounts, a decrease in the molecular weight by deterioration of the polyester caused by a visible light absorber can be prevented. When the cyclic imino ester has reacted with the polyester, it shows a tendency that its ultraviolet absorption wavelength range is generally shifted to the lower wavelength side than the ultraviolet absorption wavelength range in an unreacted state and therefore has a tendency of transmitting high-wavelength ultraviolet radiation therethrough.

When the above cyclic imino ester is added in a proper amount, a sublimate is hardly produced, so that a die and its periphery are hardly stained by film production, and since it absorbs from ultraviolet radiation to radiation around 380 nm, coloration of the film does not occur, and it is excellent in prevention of deterioration of the visible light absorber and film.

The above ultraviolet absorber is added in an amount of preferably 0.1 to 5 wt%, more preferably 0.2 to 3 wt%, based on 100 wt% of the polyester. When the amount is smaller than 0.1 wt%., an effect of preventing deterioration caused by ultraviolet radiation is small, while when it is larger than 5 wt%, the film formability of the polyester deteriorates disadvantageously.

To add the above ultraviolet absorber to the polyester, a method of kneading it into the polymer in a polyester polymerization step or a melting step prior to film formation or a method of impregnating a biaxially stretched film with it can be used, for example. From the viewpoint of preventing a decrease in the degree of polymerization of the polyester, the method of kneading the ultraviolet absorber into the polymer in the melting step prior to film formation is preferred. This kneading can be carried out by a direct addition method or a master batch method of the compound in power form.

[Protective Film on Back Side]

The easily adhesive polyester film for a film for protecting the back side of a solar cell according to the present invention can be used alone or two or more of such polyester films can be laminated and used as a film for protecting the back side of a solar cell.

To impart a water vapor barrier property to the easily adhesive polyester film for a film for protecting the back side of a solar cell according to the present invention, a film or foil having a water vapor barrier property is preferably laminated on the easily adhesive polyester film. An easily adhesive polyester film for a film for protecting the back side of a solar cell which has a water vapor barrier layer preferably shows a water vapor permeability measured in accordance with JIS Z0208-73 of not higher than 5 g/($m^2$·24h).

Illustrative examples of the film having a water vapor barrier property include a polyvinylidene chloride film, a polyvinylidene chloride coated film, a polyvinylidene fluoride coated film, a silicon oxide deposited film, an aluminum oxide deposited film, and an aluminum deposited film. Illustrative examples of the foil include aluminum foil and copper foil.

The film or foil can be used in such a form that it is laminated on a surface opposite to the EVA contacting surface of the easily adhesive polyester film for a film for protecting the back side of a solar cell according to the present invention or that it is sandwiched between two easily adhesive polyester films for a film for protecting the back side of a solar cell according to the present invention with the EVA contacting surfaces thereof facing outside. According to the present invention, there is also provided a solar cell module which comprises the film for protecting the back side of a solar cell according to the present invention.

Examples

Hereinafter, the present invention will be further described with reference to Examples. Property values were measured in the following manner.

(1) Glass Transition Point (Tg)
This was measured by use of a differential calorimeter Thermal Analyst 2000 of E.I.Dupont De Nemours & Co. at a temperature elevation rate of 20˚C/min.
(2) Intrinsic Viscosity
The viscosity of a solution comprising an orthochlorophenol solvent was measured at 35˚C.
(3) Adhesion to EVA
Two film strips each having a size of 20 mm in width x 100 mm in length and an EVA sheet (SOLAR EVA(R) SC4 of Hi-sheet Industries Co., Ltd.) strip having a size of 20 mm in width x 50 mm in length were prepared. One of the film strips, the EVA sheet strip and the other film strip were laminated in this order such that the EVA sheet strip was situated nearly in the center of the film and surfaces with which the easy adhesion of the film was to be evaluated faced the EVA, and they were pressed by a heat sealer (TP-701-B of TESTER SANGYO CO, . LTD.). As for conditions for compression bonding, after the laminate was compression-bonded at 120˚C and 0.02 MPa for 5 minutes, it was compression-bonded at 150˚C and 0.1 MPa for 25 minutes. Non-bonded film portions of the thermocompression-bonded sample were clipped by upper and lower clips at 23˚C in a 50% RH atmosphere in accordance with JIS-Z0237, and adhesion was measured at a peel angle of 180˚ and a pulling speed of 100 mm/min.
◎: 20 N/20 mm or higher ... Adhesion is very good.
○: 10 N/20 mm to lower than 20 N/20 mm ... Adhesion is good.
Δ: 5 N/20 mm to lower than 10 N/20 mm ... Adhesion is rather good.
×: lower than 5 N/20 mm ... Adhesion is poor.
(4) Durability of Adhesion to EVA
After the thermocompression-bonded sample prepared in the above (3) was treated at 85˚C and 85% RH for 1,000 hours in accordance with JIS-C8917-1998, adhesion was evaluated in the same manner as in the above (3) and compared with adhesion before the treatment and evaluated.
◎ : Adhesion Retention Rate of 75% or higher ... Adhesion durability is very good.
○: Adhesion Retention Rate of 50% to lower than 75% ... Adhesion durability is good.
Δ : Adhesion Retention Rate of 25% to lower than 50% ... Adhesion is rather good.
×: Adhesion Retention Rate of lower than 25% ... Adhesion is poor.
(5) Weather Resistance
The sample prepared in the above (3) was exposed for 1,000 hours (equivalent to 1 year of outdoor exposure) by use of a sunshine weather meter (WEL-SUN-HCL of SUGA TEST INSTRUMENTS CO., LTD.) in accordance with JIS-K-6783b to conduct an outdoor exposure accelerating test. Adhesion was measured in the same manner as in the above (3) and compared with adhesion before the accelerating test and evaluated.
◎: Adhesion Retention Rate of 75% or higher ... Weather resistance is very good.
○: Adhesion Retention Rate of 50% to lower than 75% ... Weather resistance is good.
Δ : Adhesion Retention Rate of 25% to lower than 50% ... Weather resistance is rather good.
× : Adhesion Retention Rate of lower than 25% ... Weather resistance is poor.

Examples 1 to 7 and Comparative Example 1

A polyethylene terephthalate (intrinsic viscosity: 0.62) was melt-extruded onto a rotating cooling drum kept at 20˚C to form unstretched films. Then, after the films were stretched to 3.3 times in the longitudinal direction at 100˚C, aqueous coating solutions containing the following compositions for a coating film (Table 1) in a concentration of 8 wt% were applied uniformly to both surfaces of the longitudinally stretched films by a roll coater. Then, the coated films were dried at 95˚C, stretched to 3.6 times in the transverse direction at 110˚C, shrunk by 3% in the width direction at 220˚C and heat-set to obtain polyester films each having a thickness of 50 μm. The thickness of the coating film was 0.05 μm. The evaluation results of these polyester films are shown in Table 2.

Table 1

| | Crosslinking Agent (A) | | Other Resin Component (B) | | Filler | Additive | Wetting Agent |
|---|---|---|---|---|---|---|---|
| | Kind | wt% | Kind | wt% | wt% | wt% | wt% |
| Ex.1 | A-1 | 90 | - | - | 3 | 2 | 5 |
| Ex.2 | A-1 | 60 | B-1 | 30 | 3 | 2 | 5 |
| Ex.3 | A-1 | 20 | B-1 | 70 | 3 | 2 | 5 |
| Ex.4 | A-1 | 15 | B-2 | 75 | 3 | 2 | 5 |
| Ex.5 | A-2 | 15 | B-3 | 75 | 3 | 2 | 5 |
| Ex.6 | A-3 | 20 | B-1 | 70 | 3 | 2 | 5 |
| Ex.7 | A-4 | 30 | B-1 | 60 | 3 | 2 | 5 |
| C.Ex.1 | A-1 | 5 | B-1 | 85 | 3 | 2 | 5 |

Ex.: Example, C.Ex.: Comparative Example

Crosslinking Agent A-1: oxazoline-group-containing polymer (Tg = 50˚C) comprising 30 mol% of methyl methacrylate, 30 mol% of 2-isopropenyl-2-oxazoline, 10 mol% of polyethylene oxide (n = 10) methacrylate and 30 mol% of acrylamide.
Crosslinking Agent A-2: epoxy resin, N,N,N',N'-tetraglycidyl meta-xylylene diamine Crosslinking Agent A-3: melamine resin, trimethoxymethylmelamine (trimethylolmelamine etherified with methanol)
Crosslinking Agent A-4: dimethylol ethylene urea Other Resin Component B-1: copolyester (Tg = 80˚C) comprising 65 mol% of 2, 6-naphthalene dicarboxylic acid, 30 mol% of isophthalic acid and 5 mol% of 5-sodium sulfoisophthalate as acid components and 90 mol% of ethylene glycol and 10 mol% of diethylene glycol as glycol components.
Other Resin Component B-2: copolyester (Tg = 43˚C) comprising 80 mol% of terephthalic acid, 15 mol% of isophthalic acid and 5 mol% of 5-sodium sulfoisophthalate as acid components and 60 mol% of ethylene glycol and 40 mol% of diethylene glycol as glycol components.
Other Resin Component B-3 : acrylic resin (Tg = 27˚C) comprising 55 mol% of methyl methacrylate, 40 mol% of ethyl acrylate, 3 mol% of N-methylol acrylamide and 2 mol% of 2-hydroxyethyl methacrylate.
Filler: silica filler (average particle diameter: 60 nm)
Additive: carnauba wax
Wetting Agent: polyoxyethylene (n = 7) lauryl ether

Table 2

| | Adhesion to EVA | Durability of Adhesion to EVA | Weather Resistance | Overall Evaluation |
|---|---|---|---|---|
| Ex.1 | ◎ | ◎ | ○ | ◎ |
| Ex.2 | ◎ | ◎ | ○ | ◎ |
| Ex.3 | ◎ | ○ | ○ | ◎ |
| Ex.4 | ○ | ○ | Δ | ○ |
| Ex.5 | ○ | ◎ | ○ | ◎ |
| Ex.6 | ○ | ○ | Δ | ○ |
| Ex.7 | ○ | ○ | Δ | ○ |
| C.Ex.1 | Δ | × | - | × |
| Ex.8 | ◎ | ◎ | ◎ | ◎ |
| C.Ex.2 | × | - | - | × |
| Ex.9 | ◎ | ◎ | ◎ | ◎ |
| In Table 2, a symbol "-" indicates "not evaluated".<br>Ex.: Example, C.Ex.: Comparative Example | | | | |

Example 8

A polyethylene terephthalate (intrinsic viscosity: 0.62) containing 1 wt% of ultraviolet absorber represented by the following formula was melt-extruded onto a rotating cooling drum kept at 20˚C to form an unstretched film.

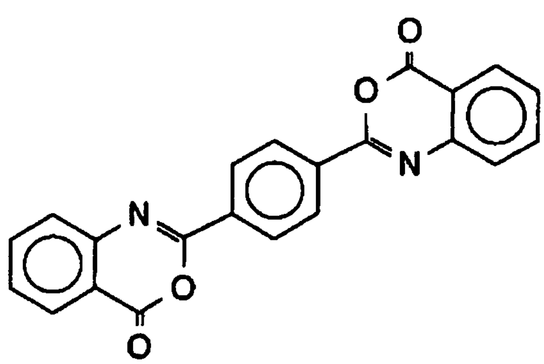

Thereafter, a film was obtained in the same manner as in Example 3. The evaluation results of this polyester film are shown in Table 2.

Comparative Example 2

A polyester film was obtained in the same manner as in Example 1 except that no aqueous solution was applied. The properties of the obtained polyester film are shown in Table 2.

Example 9

A polyethylene-2,6-naphthalate (intrinsic viscosity: 0.58) was melt-extruded onto a rotating cooling drum kept at 60˚C to form an unstretched film. Then, after the film was stretched to 3.3 times in the longitudinal direction at 140˚C, the aqueous coating solution used in Example 3 was applied uniformly to a surface of the longitudinally stretched film by a roll coater. Then, the coated film was dried at 130˚C, stretched to 3.6 times in the transverse direction at 150˚C, shrunk by 3% in the width direction at 240˚C and heat-set to obtain a polyester film having a thickness of 50 μm. The thickness of the coating film was 0.05μ m. The evaluation results of the polyester film are shown in Table 2.

Examples 10 to 13 and Comparative Example 3

A polyethylene terephthalate (intrinsic viscosity: 0.62) containing 120 ppm of porous $SiO_2$ having a particle diameter of 1.7 μm was melt-extruded onto a rotating cooling drum kept at 20˚C to form unstretched films. Then, after the films were stretched to 3.2 times in the longitudinal direction at 100˚C, aqueous coating solutions containing the following compositions for a coating film (Table 3) in a concentration of 8% were applied uniformly to both surfaces of the longitudinally stretched films by a roll coater.

Table 3

| | Polyvinyl Alcohol (A) | | Fine Particles (B) | | Crosslinking Agent (C) | | Binder (D) | | Wetting Agent |
|---|---|---|---|---|---|---|---|---|---|
| | Kind | wt% | Kind | wt% | Kind | wt% | Kind | wt% | wt% |
| Ex.10 | A-1 | 20 | B-1 | 5 | C-1 | 10 | D-1 | 60 | 5 |
| Ex.11 | A-2 | 30 | B-1 | 10 | C-1 | 10 | D-1 | 45 | 5 |
| Ex.12 | A-1 | 10 | B-2 | 3 | C-1 | 17 | D-2 | 65 | 5 |
| Ex.13 | A-1 | 15 | B-2 | 20 | C-2 | 5 | D-1 | 55 | 5 |
| C.Ex.3 | - | - | B-1 | 5 | C-1 | 5 | D-2 | 85 | 5 |

Ex.: Example, C.Ex.: Comparative Example

Polyvinyl Alcohol A-1: polyvinyl alcohol having a saponification degree of 86 to 89 mol%
Polyvinyl Alcohol A-2: polyvinyl alcohol having a saponification degree of 74 to 78 mol%
Fine Particles B-1: spherical silica particles having an average particle diameter of 100 nm
Fine Particles B-2: crosslinked acrylic particles having an average particle diameter of 100 nm
Crosslinking Agent C-1: N,N,N',N'-tetraglycidyl meta-xylene diamine, which is a compound represented by the following formula.

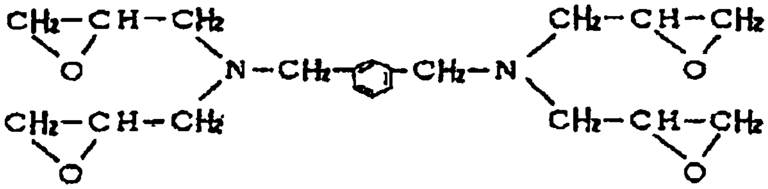

Compound C-2:
N, N, N' ,N' -tetraglycidyl-1,3-bisaminomethyl cyclohexane, which is a compound represented by the following formula.

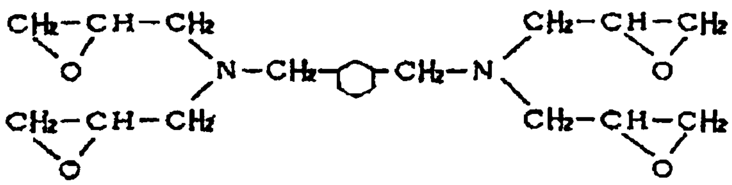

Binder D-1: copolyester (Tg = 80˚C) comprising 65 mol% of 2,6-naphthalene dicarboxylic acid, 30 mol% of isophthalic acid and 5 mol% of 5-sodium sulfoisophthalate as acid components and 90 mol% of ethylene glycol and 10 mol% of diethylene glycol as glycol components.
Binder D-2: copolyester (Tg = 43˚C) comprising 80 mol% of terephthalic acid, 15 mol% of isophthalic acid and 5 mol% of 5-sodium sulfoisophthalate as acid components and 60 mol% of ethylene glycol and 40 mol% of diethylene glycol as glycol components.

Wetting Agent: polyoxyethylene (n = 7) lauryl ether

Then, the coated films were dried at 95˚C, stretched to 3.4 times in the transverse direction at 110˚C, shrunk by 3% in the width direction at 225˚C and heat-set to obtain polyester films each having a thickness of 50 μm. The thickness of the coating film was 0.08 μm. The evaluation results of these polyester films are shown in Table 4.

Example 14

A polyethylene terephthalate (intrinsic viscosity: 0.62) containing 80 ppm of porous $SiO_2$ having a particle diameter of 1.7 μm and 1 wt% of ultraviolet absorber represented by the following formula was melt-extruded onto a rotating cooling drum kept at 20˚C to form an unstretched film.

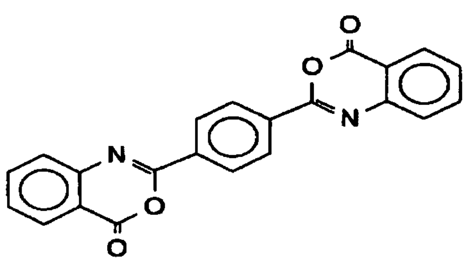

Thereafter, a film was obtained in the same manner as in Example 10. The evaluation results of this polyester film are shown in Table 4.

Comparative Example 4

A film was obtained in the same manner as in Example 10 except that no aqueous solution was applied. The properties of the obtained polyester film are shown in Table 4.

Example 15

A polyethylene-2,6-naphthalate (intrinsic viscosity: 0.58) was melt-extruded onto a rotating cooling drum kept at 60˚C to form an unstretched film. Then, after the film was stretched to 3.2 times in the longitudinal direction at 140˚C, the aqueous coating solution used in Example 10 was applied uniformly to a surface of the longitudinally stretched film by a roll coater.

Then, the coated film was dried at 130˚C, stretched to 3.4 times in the transverse direction at 150˚C, shrunk by 3% in the width direction at 240˚C and heat-set to obtain a polyester film having a thickness of 50 μm. The thickness of the coating film was 0.05 μm.

The evaluation results of the polyester film are shown in Table 4.

Table 4

| | Adhesion to EVA | Durability of Adhesion to EVA | Weather Resistance | Overall Evaluation |
|---|---|---|---|---|
| Ex.10 | ◎ | ◎ | ○ | ◎ |
| Ex.11 | ◎ | ○ | ○ | ◎ |
| Ex.12 | ○ | ◎ | ○ | ◎ |
| Ex.13 | ○ | ○ | Δ | ○ |
| C.Ex.3 | Δ | × | - | × |
| Ex.14 | ◎ | ◎ | ◎ | ◎ |
| C.Ex.4 | × | - | - | × |
| Ex.15 | ◎ | ◎ | ◎ | ◎ |
| In Table 4, a symbol "-" indicates "not evaluated".<br>Ex.: Example, C.Ex.: Comparative Example | | | | |

It is clearly understood from the results shown in Tables 2 and 4 that the biaxially oriented polyester film of the present invention has excellent adhesion to EVA and is useful as a polyester film for a film for protecting the back side of a solar cell.

## Claims

1. An easily adhesive polyester film which is used for protection of the back side of a solar cell, the adhesive polyester film comprising a polyester film and a resin film situated on a surface of the polyester film,
the resin film comprising a crosslinking agent and a resin selected from the group consisting of a polyester resin having a glass transition point of 20 to 100˚C, an acrylic resin having a glass transition point of 20 to 100˚C, a combination of the resins and a combination of at least one of the resins and a polyvinyl alcohol having a saponification degree of 70 to 90 mol%.

2. The easily adhesive polyester film of claim 1, wherein the crosslinking agent is at least one selected from the group consisting of an
oxazoline-group-containing polymer, an urea resin, a melamine resin and an epoxy resin.

3. The easily adhesive polyester film of claim 1, wherein the resin film comprises 20 to 95 wt% of the resin and 5 to 80 wt% of the crosslinking agent.

4. The easily adhesive polyester film of claim 1, wherein the resin film comprises 1 to 20 wt% of fine particles having an average particle diameter of 20 to 200 nm.

5. The easily adhesive polyester film of claim 1, wherein the polyester film is a 2,6-naphthalene dicarboxylate film.

6. The easily adhesive polyester film of claim 1, wherein the polyester film comprises 0.1 to 5 wt% of ultraviolet absorber.

7. The easily adhesive polyester film of claim 1, wherein the ultraviolet absorber is at least one compound selected

from the group consisting of a cyclic imino ester represented by the following formula (1) :

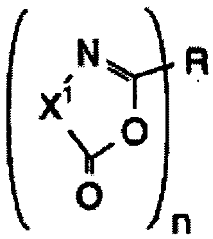

• • • (I)

(wherein $X^1$ is a divalent aromatic residue having two bonding hands at first and second positions, n is 1, 2 or 3, $R^1$ is an n-valent hydrocarbon residue which may contain a hetero atom or $R^1$ may be a direct bond when n = 2), and a cyclic imino ester represented by the following formula (II):

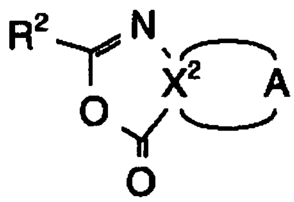

• • • (II)

(wherein A is a group represented by the following formula (II)-a:

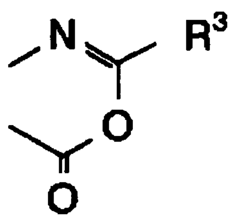

• • • (II) -a

or a group represented by the following formula (II) -b:

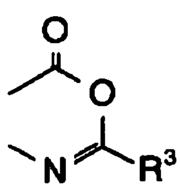

• • • (II) -b

, $R^2$ and $R^3$ are the same or different and are a monovalent hydrocarbon residue, and $X^2$ is a tetravalent aromatic residue which may contain a hetero atom).

**8.** The easily adhesive polyester film of claim 1, wherein the polyester film is a biaxially stretched polyester film, and the resin film is formed by applying a coating solution on a polyester film before completion of crystalline orientation of the polyester film and drying, stretching and heat-treating the film.

**9.** A film for protecting the back side of a solar cell, comprising the easily adhesive polyester film of any of claims 1 to 7.

**10.** Use of the easily adhesive polyester film of any of claims 1 to 7 for protecting the back side of a solar cell.

**11.** A solar cell module comprising the protective film of claim 9.

**INTERNATIONAL SEARCH REPORT**

International application No.
PCT/JP2005/022034

A. CLASSIFICATION OF SUBJECT MATTER
*H01L31/048*(2006.01)

According to International Patent Classification (IPC) or to both national classification and IPC

B. FIELDS SEARCHED

Minimum documentation searched (classification system followed by classification symbols)
*H01L31/00-31/20*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-326374 A (Dainippon Printing Co., Ltd.), 22 November, 2001 (22.11.01), (Family: none) | 1-11 |
| Y | JP 2001-44481 A (Dainippon Printing Co., Ltd.), 16 February, 2001 (16.02.01), (Family: none) | 1-11 |
| Y | JP 2002-134768 A (Kyocera Corp.), 10 May, 2002 (10.05.02), (Family: none) | 1-11 |
| Y | JP 2002-185026 A (Bridgestone Corp.), 28 June, 2002 (28.06.02), (Family: none) | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>03 March, 2006 (03.03.06) | Date of mailing of the international search report<br>14 March, 2006 (14.03.06) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No.
PCT/JP2005/022034

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2001-77390 A (Canon Inc.),<br>23 March, 2001 (23.03.01),<br>& EP 1065731 A & CN 1280393 A<br>& US 6414236 B | 1-11 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6038264 U
- JP 11261085 A
- JP 11186575 A
- JP 2003060218 A
- JP 63048884 A
- JP 2060941 A
- JP 2099537 A
- JP 59012952 A
- US 4291152 A